# EUROPEAN PATENT APPLICATION

(11) **EP 1 744 360 A2**
(43) Date of publication of application: **17.01.2007**
(21) Application number: 06076400.8
(22) Date of filing: 12.07.2006
(51) Int. Cl.: H01L 23/473, H01L 23/36

(54) **Heatsink with adapted backplate**

(30) Priority: 12.07.2005 US 698644 P; 10.07.2006 US 483467
(71) Applicant: INTERNATIONAL RECTIFIER CORPORATION, El Segundo, CA 90245 (US)
(72) Inventor: Kienitz, Stefan, 40217 Düsseldorf (DE); Rachmann, Klaus, 47809 Krefeld (DE); Thor, Volker, 45279 Krefeld (DE); Nejati, Shahrouz, 47800 Krefeld (DE)
(74) Representative: Land, Addick Adrianus Gosling

(57) **Abstract**

A fluid-cooled heatsink and backplate, for example, for an electronic power module in an automotive application are provided, the backplate formed with a set of grooves, and the heatsink formed with a set of ribs corresponding to the set of grooves and extending into and affixed to the set of grooves. Glue or adhesive material, such as silicone or silicone o-rings, may be provided between the set of ribs and the set of grooves to secure the backplate to the heatsink. A second set of ribs extending from the heatsink may also be included, such that space is allowed between each rib of the second set of ribs and the backplate. An epoxy-adhesive material may be disposed between the second set of ribs and the backplate, or the second set of ribs may be welded or partially welded. Also provided are the backplate and a method of manufacture.

## Description

### RELATED APPLICATION

This application is based on and claims benefit of United States Provisional Application No. 60/698,644, filed on July 12, 2005, entitled Heatsink with Glued Backplate, to which a claim of priority is hereby made and the disclosure of which is incorporated in full by reference.

### FIELD OF THE INVENTION

The present invention relates to the field of heatsinks, heatpipes, radiators and cooling units, and particularly to metallic heatsinks for cooling electronic power modules and transistors in automotive, motor vehicle and under the hood applications and the like, and to methods of producing the same.

### BACKGROUND OF THE INVENTION

Electronic components, including electronic power modules and transistors to control the engine and/or for other under the hood functions, are in wide use in the automotive and motor vehicle industry. Such electronic components typically need to be cooled by means of heatsinks or heatpipes placed immediately adjacent to them. For example, certain types of electronic power modules, including transistors, such as FETs, or some types of semiconductors and silicon chips or the like, generate heat and must be cooled for effective use over a period of time. For heatsinks using a fluid or liquid as a coolant medium, the heatsink needs to contain the fluid and therefore has a backplate, typically arranged away from the electronic component to be cooled. Often water, or water laced with a chemical, is used as such coolant.

However, attaching and securing the backplate to the heatsink to achieve a degree of mechanical strength poses a number of challenges. Screws, glue or other affixing means for the attachment of the backplate to the heatsink may be used, however placing glue or adhesive on the distal ends of the ribs or fins of the backplate is not always sufficient to secure the backplate to the heatsink properly. Screws and other affixing means can take up valuable space from the cooling channels inside the heatsink, and the use of many parts for assembly could require additional inventory and expense. A streamlined, simple design that saves space, including space in the cooling channel, would be advantageous.

### SUMMARY OF THE INVENTION

A fluid-cooled heatsink and backplate are provided, the backplate formed with a set of grooves, and the heatsink formed with a first set of ribs corresponding to the set of grooves and extending into and affixed to the set of grooves.

The heatsink and backplate may also include one or more glue material or adhesive material disposed between the first set of ribs and the set of grooves to secure the backplate to the heatsink. For example, the adhesive material may be a silicone-adhesive material.

A second set of ribs extending from the heatsink may also be included, such that a distal end of each rib of the second set of ribs lines up away from each groove of the plurality of grooves and such that space is allowed between each rib of the second set of ribs and the backplate. An epoxy-adhesive material may be disposed between the second set of ribs and the backplate. Also, a silicone adhesive material may be provided between the first set of ribs and the grooves to secure the backplate to the heatsink, and the second set of ribs may be welded or partially welded to the grooves. Moreover, a set of silicone o-rings may be arranged in the sealing gaps between the grooves and the first set of ribs. Further, the first set of ribs may be welded or partially welded to the grooves.

Stand-off pins may also be inserted to secure the backplate to the heatsink. The stand-off pins may be made of aluminum, aluminum alloy or steel.

The coolant fluid may be water or primarily water. The heatsink and backplate may be die-cast or otherwise formed of aluminum or aluminum alloy. Such a heatsink and backplate would be typically adapted for an electronic power module in an automotive application.

Other features and advantages of the present invention will become apparent from the following description of the invention which refers to the accompanying drawings.

### BRIEF DESCRIPTION OF THE FIGURES

Figure 1 is a sectional view of a heatsink with backplate, according to an aspect of the present invention.

Figure 2 is a close-up sectional view of ribs of the heatsink in engagement position with the backplate, according to an aspect of the present invention.

### DETAILED DESCRIPTION OF THE INVENTION

Figure I is a cross-sectional schematic illustration of the heatsink with the backplate 20. The heatsink 10 includes a set of ribs or fins, such that each rib 13 extends out toward the backplate 20. Backplate 20 has a series of recesses or grooves 21 formed in the backplate 20 for receiving the ribs of the heatsink 10. The rib 13 and the other ribs of the heatsink are shown as tapered toward the backplate, but it will be understood that ribs with other shapes, such as rectangular or cylindrical ribs, are also contemplated. Typically, backplate 20 is formed during its manufacture with the grooves 21 in place. For example, the backplate 20 may be made primarily of aluminum or aluminum alloy and molded or machined with the grooves 21. Typically, the backplate 20 is manufactured by well-known die casting methods. Similarly, the heatsink 10 is formed integrally with the ribs 13 or fins, and may be made of metals, such as aluminum or aluminum alloy. Typically, such a heat sink with backplate would be designed to withstand more than three bar pressure.

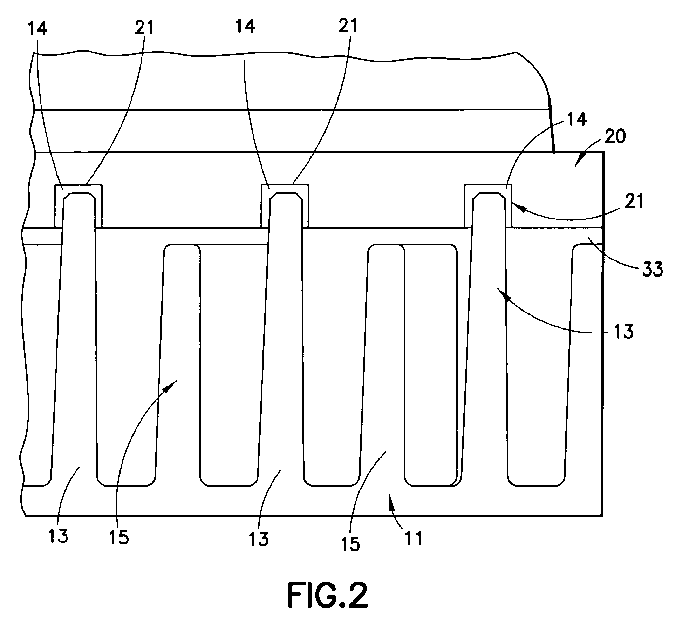

Referring to Figure 2, adhesive material 14 , such as a glue, epoxy or resin, shown in black, is introduced into the groove 21 to secure the rib 13. The grooves with the adhesive material 14 are then mated with the ribs to secure the backplate 20 to the heatsink 10. However the ribs or fins can also be attached or affixed via a silicone adhesive or by using a silicone o-ring pressed into the sealing gap. It will be understood that the steps of securing the backplate 20 to the heatsink 10 may be varied: the adhesive or the o-ring can be placed on or around the distal end 30 of the ribs 13 (and the distal ends of the remaining ribs) and then the ribs can be inserted into the grooves of the backplate 20.

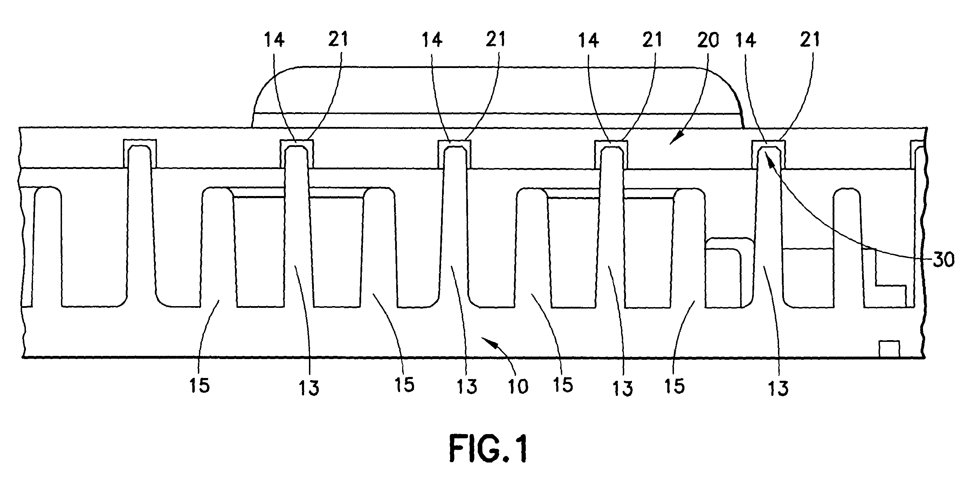

Also shown in Figures 1 and 2 are a set of short ribs extending from the heatsink 10. Each short rib 15 is adjacent to the taller ribs (the taller ribs are the ribs in mating position with the grooves of the backplate 20) in an alternating pattern. The short rib 15 may be affixed to the backplate to provide additional strength to the heatsink backplate combination. The short ribs may be adhered using an adhesive or glue or may be welded or partially welded at or near the distal ends of the short ribs.

Further, bolts or stand-off pins, also made of metal, such as aluminum, aluminum alloy or steel, may be pressed into the heatsink and the backplate to define the thickness of the adhesive and to provide additional strength during the assembly step. That is, by using a limited number of such pins during the assembly of the heatsink with backplate 20, including during the curing of the glue, adhesive or o-ring, or during the welding of the fins to the backplate, the backplate and the fins would already be one unit. Thus, during the curing step and/or the welding step, the heatsink 10 and backplate 20 would be held in position without additional fixture. However, it will be understood that these means for affixing the backplate 20 to the heatsink 10 could be varied, alternated, or otherwise combined, as would be understood by a person of ordinary skill.

Accordingly, such a heat sink with backplate, die cast or otherwise formed in two parts, can provide a lower-priced and space-saving design and may require no additional screws. This could facilitate more effective use of the cooling channels.

Although the present invention has been described in relation to particular embodiments thereof, many other variations, modifications and other combinations features described, and other uses and applications will become apparent to those skilled in the art. It is preferred, therefore, that the present invention be limited not by the specific disclosure herein, but only by the appended claims.

## Claims

1. A fluid-cooled heatsink and backplate comprising:
the backplate formed with a plurality of grooves; and
the heatsink formed with a first plurality of ribs corresponding to the plurality of grooves and extending into and affixed to the plurality of grooves.

2. The heatsink and backplate of claim 1, further comprising at least one of a glue material or an adhesive material disposed between the first plurality of ribs and the plurality of grooves to secure the backplate to the heatsink.

3. The heatsink and backplate of claim 2, wherein the at least one of a glue material or an adhesive material comprises a silicone-adhesive material.

4. The heatsink and backplate of claim 1, 2 or 3, further comprising a second plurality of ribs extending from the heatsink disposed such that a distal end of each rib of the second plurality of ribs lines up away from each groove of the plurality of grooves and such that space is allowed between each rib of the second plurality of ribs and the backplate.

5. The heatsink and backplate of claim 4, further comprising an epoxy-adhesive material disposed between the second plurality of ribs and the backplate.

6. The heatsink and backplate of claim 4, further comprising at least one of a silicone adhesive material disposed between the first plurality of ribs and the plurality of grooves to secure the backplate to the heatsink, wherein the second plurality of ribs are at least one of welded or partially welded to the plurality of grooves.

7. The heatsink and backplate of any of claims 1-6, further comprising a plurality of silicone o-rings disposed in a plurality of sealing gaps between the plurality of grooves and the first plurality of ribs.

8. The heatsink and backplate of any of claims 1-7, wherein the first plurality of ribs are at least one of welded or partially welded to the plurality of grooves.

9. The heatsink and backplate of any of claims 1-8, further comprising stand-off pins securing the backplate to the heatsink.

10. The heatsink and backplate of claim 9, wherein the stand-off pins and/or heatsink, and/or backplate are comprised of one of aluminum, aluminum alloy or steel.

11. The heatsink and backplate of claim 1, wherein the fluid comprises water.

12. The heatsink and backplate of any of claims 1-11, wherein the heatsink is adapted for an electronic power module in an automotive application.

13. A backplate for a water-cooled heatsink for an electronic power module in an automotive application, the backplate formed with a plurality of grooves adapted to receive distal ends of a corresponding plurality of ribs extending from the heatsink.

14. The backplate of claim 13, wherein the backplate is comprised of aluminum or aluminum alloy.

15. A method of forming a heatsink and backplate, the method comprising:
forming the backplate with a plurality of grooves disposed to receive a corresponding first plurality of ribs;
forming the heatsink with the corresponding first plurality of ribs; and
securing the corresponding first plurality of ribs into the plurality of grooves.

16. The method of claim 15, wherein the heatsink and/or backplate according to any of claims 1-15 is used.
